# EUROPEAN PATENT APPLICATION

(11) **EP 2 479 638 A2**
(43) Date of publication of application: **25.07.2012**
(21) Application number: 12425010.1
(22) Date of filing: 18.01.2012
(51) Int. Cl.: G06F 1/16

(54) **improved control unit**

(30) Priority: 24.01.2011 IT RM20110009 U
(71) Applicant: Bitron S.p.A., 10095 Grugliasco, Torino (IT)
(72) Inventor: Promutico, Fabrizio, 10095 Grugliasco (TO) (IT)
(74) Representative: Tiburzi, Andrea

(57) **Abstract**

The present invention concerns a Control unit (1) electrically connectable with a motherboard (S) of a household appliance or the like, comprising a containment enclosure (20) provided with fixing means (41') to said motherboard (S), a mechanical or electromechanical device (30) arranged within said containment enclosure (20), and an interface and control board (40), which is also arranged within said containment enclosure (20), said control unit (1) being characterized in that when said containment enclosure (20) is fixed to said motherboard (S) by said fixing means (41'), said interface and control board (40) is arranged substantially perpendicular to said motherboard (S).

## Description

The present invention relates to an improved control unit.

More specifically, the invention concerns a control unit studied and realized in particular to allow the replacement of electromechanical devices, such as turning on switches, program selectors and the like, without the need to replace or to substantially modify the motherboard of a household appliance.

In the following, the description will be directed to a switch device for washing machines or household appliances in general, but it is clear that the same should not be considered limited to this specific use.

As it is well known, in the field of the household appliances, technology advances very quickly. Therefore, often household appliances manufacturers design electronic motherboards for the control of the household appliance, so that they can be easily adapted to any technological developments, as new functions, etc.. In this way, any changes can be made just by reprogramming of microcontrollers or of EEPROM memories.

Sometimes, however, making changes both of electronic type, such as those exemplified above, as well as to electromechanical parts, happens. For example, considering the case of the directive on energy consumption, which is expected to enter into force already from 2013, it will be required to eliminate power consumptions of household appliances even during standby. From a technical standpoint, this means to provide a physical opening of the connection of the household appliance from the electricity supply network, so as to prevent any power consumption when the household appliance is not in use. In order to achieve this, changing the operating software of the motherboard is not sufficient. In fact, acting on the interaction between the household appliance electronic board and a possible mechanical / electro-mechanical device to be installed, together with its electronic control board for interfacing with the logic of the household appliance, is required. In general, in said electronic control board, especially in the adaptation of household appliances already in use, it is not always easy to have new components, also for reasons of space.

In light of the above, the need to have a solution that allows the adjustment of a household appliance to a different mechanical / electromechanical device, by making the fewest changes to the electronics and minimizing the space occupied, appears evident.

The main object of the invention is, therefore, to provide a control unit configurable to allow the interaction between a motherboard and a mechanical / electromechanical device without occupying space.

These and other results are obtained according to the invention with a control unit capable of housing, in an appropriate way, the interface electronic board for controlling a mechanical / electromechanical device.

It is therefore a specific object of the present invention a control unit electrically connectable with a motherboard of a household appliance or the like, comprising a containment enclosure provided with fixing means to said motherboard, a mechanical or electromechanical device arranged within said containment enclosure, and an interface and control board, which is also arranged within said containment enclosure, said control unit being **characterized in that** when said containment enclosure is fixed to said motherboard by said fixing means, said interface and control board is arranged substantially perpendicular to said motherboard.

Always according to the invention, said containment enclosure could have a housing for said interface and control board.

Still according to the invention, said containment enclosure could have at least one opening, which is insertable in an electrical connector, and in that said interface and control board is provided with one or more first electrical terminals, connectable to a corresponding socket fixed on said motherboard, and with one or more second electrical terminals, arranged in correspondence with said at least one opening, so that said one or more second electrical terminals are connectable with said electrical connector, said interface and control board being controllable both by means of said first terminal, as well as by said second terminals.

Advantageously according to the invention, said control board could comprise a power device or power circuit, having a TRIAC, an IGBT or the like, for powering a coil of a relay or a coil provided with a core movable by effect of the magnetic field generated by said coil, when it is powered, said movable core interacting with said mechanical or electromechanical device.

Further according to the invention, said control board could comprise a power device or power circuit, having a TRIAC, an IGBT or the like, for powering a PTC (Positive Temperature Coefficient) resistor, arranged close to a bi-metal element, so that the passage of current through said PTC resistor causes an increase in temperature of the PTC resistor itself and the bi-metal element, said bi-metal element changing its shape interacting and moving with said mechanical or electromechanical device.

Always according to the invention, said fixing means could comprise a plurality of fixing pins inserted in corresponding holes, made on said motherboard.

Still according to the invention, said mechanical or electromechanical device could be a switch, and / or rotary switch device and / or a program selector and the like.

Advantageously according to the invention, said interface and control board could be configured and programmed and adapted to the operation of said motherboard.

The present invention will be now described, for illustrative but not limitative purposes, according to its preferred embodiments, with particular reference to the figures of the enclosed drawings, wherein:
figure 1 shows a side sectional view of a first embodiment of a control unit according to the present invention;
figure 2 shows a exploded perspective view of a control unit according to figure 1;
figure 3 shows a portion of a containment enclosure according to figure 1;
figure 4 shows a side sectional view of a further embodiment of a control unit according to the present invention;

In the various figures, similar parts will be indicated by the same reference numbers.

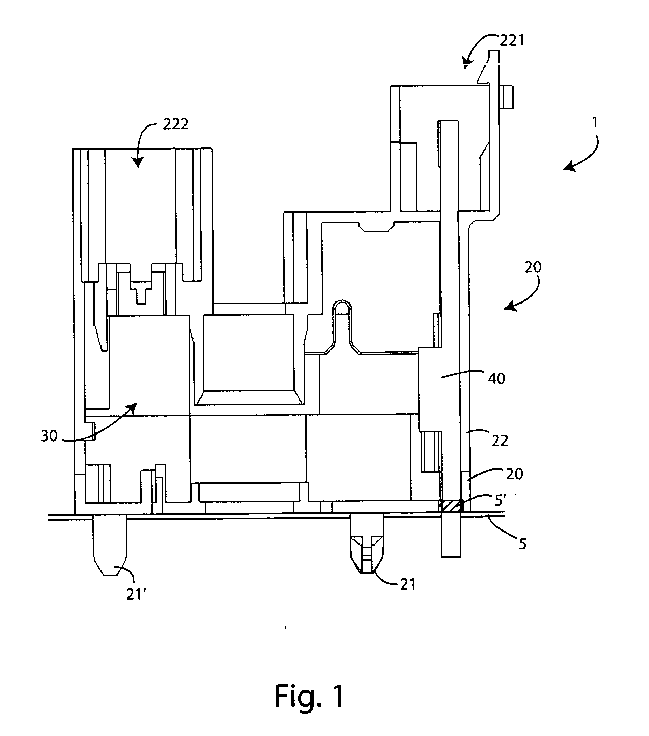

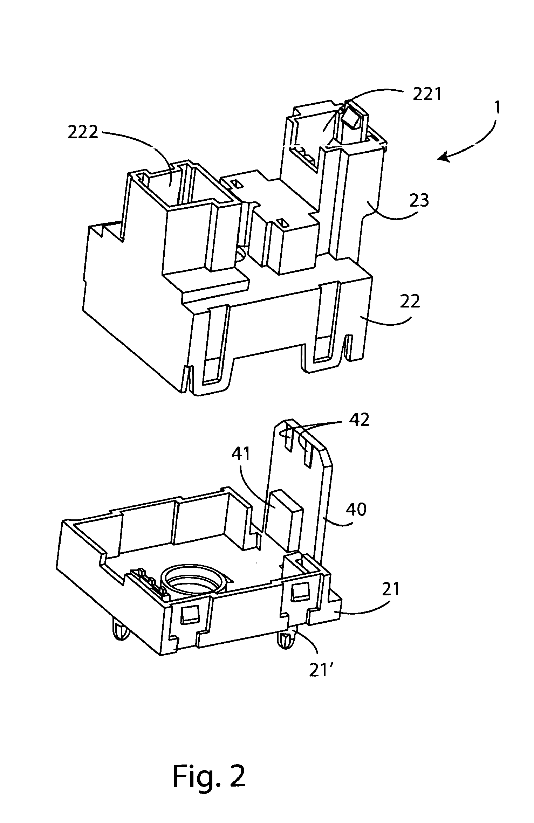

Making reference to figures 1 - 3, an electromechanical control unit 1 can be seen, comprising containment enclosure 20 containing a mechanical or electromechanical device 30 and an interface and control board 40.

Said containment enclosure 20 comprises a base portion 21, having a plurality of fixing pins 21', and an upper portion 22, which can be joint coupled with said base portion 21.

Said upper portion 22 has also a first opening 221, which is insertable into an electrical connector, and a second opening 222, in which a further electrical connector can be inserted, a connector for power supply.

Said enclosure 20 has a housing 23 for said interface and control board 40, which is arranged vertically with respect to the motherboard S, on which said containment enclosure 1 is installed.

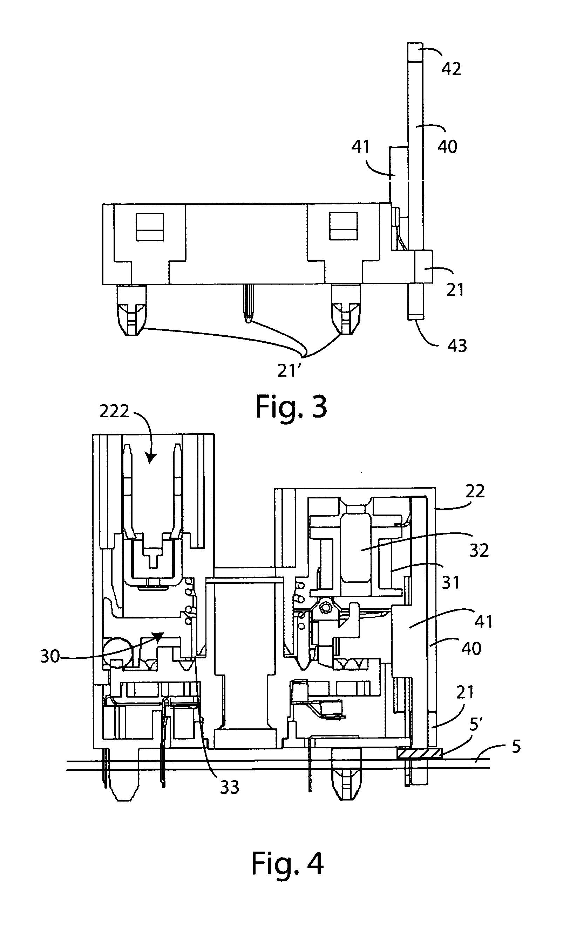

Said interface and control board 40 comprises, in the case of the embodiment according to figure 4, a power device or power circuit 41, which can be constituted for example by a TRIAC, an IGBT or the like, adapted to drive a relay or, as shown in the figure, a coil 31, in which a core 32, movable by the magnetic field generated by said coil 31 when it is powered, is placed. Said movable core 32 is arranged so as to interact with a mechanical mechanism 33, placed within said containment enclosure 20. In this embodiment, the device does not provide the first opening.

Said interface and control board 40 of said electromechanical control unit 1 also comprises first terminals 42 and second terminals 43, arranged opposite to said first terminals 42, with respect to the printed circuit of said interface and control board 40. Said interface and control board 40 can be controlled either by said first terminals 42, or by said second terminals 43.

The installation of said electromechanical control unit 1, for example for the installation of an electromechanical power switch or a rotary switch device, is as follows. If the motherboard S of the household appliance is arranged for the installation of said electromechanical control unit 1, said motherboard S comprises a suitable socket S', otherwise, providing a wired connection, between said motherboard S and said electromechanical control unit 1, is necessary.

Moreover, always for installing said electromechanical control unit 1, making holes on said motherboard S is required, in which said fixing pins 21' of said base portion 21 of said containment enclosure 20 are inserted.

When said electromechanical control unit 1 is placed on the motherboard S, fixing pins 21' are inserted in the above mentioned holes, and second terminals 43 of said interface and control board 40 are inserted in said socket S'. In case of motherboard S is not electrically prearranged for the connection to said electromechanical control unit 1, then the electrical connection between said motherboard S of said household appliance and said interface and control board 40 would be by means of electrical cable, connected at one end with said motherboard S and, provided at the other end with a connector insertable into said first opening 221 of said upper portion 22 of the said containment enclosure 20. Said connector is adapted to provide an electrical connection with said first terminals 42. In this way, as it can be seen, household appliance motherboard S can control the electromechanical control unit 1 regardless of the prearrangement of the same to the installation of an additional electromechanical control unit 1. When said electromechanical control unit 1 is installed, said interface and control board 40 is arranged perpendicular with respect to the motherboard S. This allows both to reduce the occupation of total space of said electromechanical control unit 1, and, as seen above, to provide an electrical connection of said electromechanical control unit 1 with said motherboard S above or below, giving remarkable installation versatility.

The present invention has been described for illustrative but not limitative purposes, according to its preferred embodiments, but it is to be understood that modifications and/or changes can be introduced by those skilled in the art without departing from the relevant scope as defined in the enclosed claims.

## Claims

1. Control unit (1) electrically connectable with a motherboard (S) of a household appliance or the like, comprising
a containment enclosure (20) provided with fixing means (41') to said motherboard (S),
a mechanical or electromechanical device (30) arranged within said containment enclosure (20), and
an interface and control board (40), which is also arranged within said containment enclosure (20),
said control unit (1) being **characterized in that** when said containment enclosure (20) is fixed to said motherboard (S) by said fixing means (41'), said interface and control board (40) is arranged substantially perpendicular to said motherboard (S).

2. Unit (1) according to claim 1, **characterized in that** said containment enclosure (20) has a housing (23) for said interface and control board (40).

3. Unit (1) according to anyone of the preceding claims, **characterized in that** said containment enclosure (20) has at least one opening (221), which is insertable in an electrical connector, and **in that** said interface and control board (40) is provided with one or more first electrical terminals (42), connectable to a corresponding socket (S') fixed on said motherboard (S), and with one or more second electrical terminals (43), arranged in correspondence with said at least one opening (221), so that said one or more second electrical terminals (43) are connectable with said electrical connector, said interface and control board (40) being controllable both by means of said first terminal (42), as well as by said second terminals (43).

4. Unit (1) according to anyone of the preceding claims, **characterized in that** said control board comprises a power device or power circuit (41), having a TRIAC, an IGBT or the like, for powering a coil of a relay or a coil (31) provided with a core (32) movable by effect of the magnetic field generated by said coil (31), when it is powered, said movable core interacting with said mechanical or electromechanical device (30).

5. Unit (1) according to anyone of claims 1-3, **characterized in that** said control board comprises a power device or power circuit (41), having a TRIAC, an IGBT or the like, for powering a PTC (Positive Temperature Coefficient) resistor, arranged close to a bi-metal element, so that the passage of current through said PTC resistor causes an increase in temperature of the PTC resistor itself and the bi-metal element, said bi-metal element changing its shape interacting and moving with said mechanical or electromechanical device (30).

6. Unit (1) according to anyone of the preceding claims, **characterized in that** said fixing means comprise a plurality of fixing pins (21') inserted in corresponding holes, made on said motherboard (S).

7. Unit (1) according to anyone of the preceding claims, **characterized in that** said mechanical or electromechanical device (30) is a switch, and / or rotary switch device and / or a program selector and the like.

8. Unit (1) according to anyone of the preceding claims, **characterized in that** said interface and control board (40) can be configured and programmed and adapted to the operation of said motherboard.
